# EUROPEAN PATENT APPLICATION

(11) **EP 4 470 824 A1**
(43) Date of publication of application: **04.12.2024**
(21) Application number: 24178166.5
(22) Date of filing: 27.05.2024
(51) Int. Cl.: B60L 53/53, G01R 31/392, H01M 10/42, H01M 10/48, H02J 7/00

(54) **POWER STORAGE SYSTEM AND BATTERY MANAGEMENT SYSTEM**

(30) Priority: 30.05.2023 JP 2023088725
(71) Applicant: Ricoh Company, Ltd., Tokyo 143-8555 (JP)
(72) Inventor: ONISHI, Takanori, Tokyo, 143-8555 (JP)
(74) Representative: SSM Sandmair

(57) **Abstract**

A power storage system (12) includes a reusable battery (42) used as a storage battery, a battery diagnosis unit (52), a battery life estimation unit (70), a battery replacement determination unit (74), and a battery replacement request output unit (76). The battery diagnosis unit (52) outputs a diagnosis result of diagnosing the reusable battery (42) while the reusable battery (42) is being used. The battery life estimation unit (70) estimates a battery life of the reusable battery (42) based on the diagnosis result. The battery replacement determination unit (74) determines whether to replace the reusable battery (42) based on the estimated battery life. When it is determined to replace the reusable battery (42), the battery replacement request output unit (76) outputs a battery replacement request to a battery replacement management system (20) that manages information of another reusable battery (42) usable as the storage battery.

## Description

### BACKGROUND

### Technical Field

Embodiments of this disclosure relate to a power storage system and a battery management system.

### Related Art

Recent years have seen the effective use of a surplus of generated power with a solar power generator and a power storage system. Due to the expensiveness of storage batteries included in the power storage system, used storage batteries are collected from electric vehicles (EVs) or hybrid electric vehicles (HEVs) and remanufactured into reusable batteries for cost reduction of the storage batteries of the power storage system. For example, Japanese Unexamined Patent Application Publication No. 2021-048997 discloses reusing, as stationary storage batteries, secondary batteries such as lithium-ion batteries (LIBs) used in EVs or HEVs.

Storage batteries used in EVs or HEVs, however, vary in deterioration level. Therefore, employing the used storage batteries of EVs or HEVs as the reusable batteries of the power storage system creates quality concerns associated with reusable batteries. This makes it difficult to reduce the cost of the operation and the maintenance and inspection of the power storage system, posing a financial obstacle to the introduction of the power storage system.

### SUMMARY

In one embodiment of this invention, there is provided a power storage system (12) that includes, for example, a reusable battery (42), a battery diagnosis unit (52), a battery life estimation unit (70), a battery replacement determination unit (74), and a battery replacement request output unit (76). The reusable battery (42) is used as a storage battery. The battery diagnosis unit (52) outputs a diagnosis result of diagnosing the reusable battery (42) while the reusable battery (42) is being used. The battery life estimation unit (70) estimates a battery life of the reusable battery (42) based on the diagnosis result. The battery replacement determination unit (74) determines whether to replace the reusable battery (42) based on the estimated battery life. When it is determined to replace the reusable battery (42), the battery replacement request output unit (76) outputs a battery replacement request to a battery replacement management system (20) that manages information of another reusable battery (42) usable as the storage battery.

In one embodiment of this invention, there is provided a battery management system (1) that includes, for example, a power generator (10) and the above-described power storage system (12) to store power generated by the power generator (10). In the power storage system (12), the battery diagnosis unit (52) may acquire at least one of a voltage, a current, and a temperature of the reusable battery (42) as data of the reusable battery (42), perform deterioration diagnosis on the reusable battery (42) based on the acquired data of the reusable battery (42), and output a result of the deterioration diagnosis to the battery life estimation unit (70).

According to one or more embodiments of the present invention, the cost of introducing a power storage system using reusable batteries is reduced.

### BRIEF DESCRIPTION OF THE DRAWINGS

A more complete appreciation of embodiments of the present disclosure and many of the attendant advantages and features thereof can be readily obtained and understood from the following detailed description with reference to the accompanying drawings, wherein:
FIG. 1 is a diagram illustrating an exemplary configuration of a battery management system according to an embodiment of the present invention;
FIG. 2 is a diagram illustrating an exemplary hardware configuration of a power storage system included in the battery management system of the embodiment;
FIG. 3 is a diagram illustrating an exemplary hardware configuration of a computer included in the battery management system of the embodiment;
FIG. 4 is a diagram illustrating an exemplary functional configuration of the power storage system of the embodiment;
FIG. 5 is a diagram illustrating an exemplary functional configuration of a battery replacement management system included in the battery management system of the embodiment;
FIG. 6 is a flowchart illustrating an exemplary processing procedure of the battery management system of the embodiment;
FIG. 7 is a diagram illustrating an exemplary process of the battery replacement management system of the embodiment;
FIG. 8 is a flowchart illustrating an exemplary processing procedure of the battery replacement management system of the embodiment;
FIG. 9 is a diagram illustrating an exemplary business model implemented by the battery management system of the embodiment;
FIG. 10 is a diagram illustrating an example of a circular flow implemented by the battery management system of the embodiment;
FIG. 11 is a diagram illustrating another exemplary configuration of the battery management system of the embodiment; and
FIG. 12 is a diagram illustrating still another exemplary configuration of the battery management system of the embodiment.

The accompanying drawings are intended to depict embodiments of the present disclosure and should not be interpreted to limit the scope thereof. The accompanying drawings are not to be considered as drawn to scale unless explicitly noted. Also, identical or similar reference numerals designate identical or similar components throughout the several views.

### DETAILED DESCRIPTION

In describing embodiments illustrated in the drawings, specific terminology is employed for the sake of clarity. However, the disclosure of this specification is not intended to be limited to the specific terminology so selected and it is to be understood that each specific element includes all technical equivalents that have a similar function, operate in a similar manner, and achieve a similar result.

Referring now to the drawings, embodiments of the present disclosure are described below. As used herein, the singular forms "a," "an," and "the" are intended to include the plural forms as well, unless the context clearly indicates otherwise.

The following description will be given of an embodiment example in which lithium-ion secondary batteries for in-vehicle use are remanufactured to be used in a power storage system that stores a surplus of solar-generated power, to thereby promote the use of renewable energy. Herein, the term "remanufacturing" refers to disassembling and recycling a discarded product into a reusable part to be reused.

In terms of commercialization, selling a customer a set of equipment including a power storage system is a typical approach. The set of equipment including the power storage system, however, is expensive even if the equipment set uses remanufactured reusable batteries, consequently creating a financial obstacle to the introduction of the power storage system.

Further, the power storage system employing the reusable batteries poses quality concerns associated with the reusable batteries. To address these concerns, simulations may be performed for deterioration diagnosis, anomaly diagnosis, or lifetime prediction of the reusable batteries.

The power storage system includes battery packs each with multiple (e.g., 96) battery cells connected in series. The battery packs are connected in parallel to increase the battery capacity. To examine the quality (e.g., the deterioration or safety level) of the batteries and eliminate concerns, the conditions of all battery cells in the power storage system should be examined. Such examination involves the acquisition of a vast amount of battery data (big data), the analysis of the acquired data with arithmetic processing, and the prediction by simulation.

Consequently, the power storage system using the reusable batteries entails the cost of a battery management system that manages the quality of the reusable batteries or labor cost for managing the quality of the reusable batteries, presenting a financial obstacle to the introduction of the power storage system using the reusable batteries.

As an example of a method of reducing the initial investment by a customer to start using a solar power generator and a power storage system, there is solar lease, for example. As for the solar power generator, there is also a method of reducing the initial investment by the customer based on a power purchase agreement (PPA) between an operator of solar power generation business and a customer who desires to purchase power derived from renewable energy.

The above-described solar lease or PPA, however, does not reduce a burden on the operator that supplies power to the customer with the power storage system using the reusable batteries, making it difficult for the operator to keep the business viable. For the operator to sustain a viable business of supplying power to the customer with the power storage system using the reusable batteries, therefore, the cost of the power storage system and the cost of managing the quality of the reusable batteries should be reduced.

Since storage batteries of the power storage system account for a large fraction of the cost of the power storage system, the cost of the power storage system may be reduced by collecting discarded lithium-ion batteries of electric vehicles (EVs) or hybrid electric vehicles (HEVs) and reusing the collected batteries as the storage batteries of the power storage system.

To reduce the cost of quality management of the reusable batteries, a system should be provided to improve the efficiency of an operation of monitoring the conditions of the reusable batteries and replacing the reusable batteries as necessary to maintain the quality and safety thereof.

In the present embodiment, a power generator such as a solar power generator and a power storage system are installed near, for example, a data center (DC) of the customer as an example of a power supply destination. The power generator generates renewable energy power. The power storage system stores the power generated by the power generator. In the embodiment, the conditions of the reusable batteries in the power storage system are monitored in real time to determine whether any of the reusable batteries should be replaced. This leads to a reduction in the lead time for replacing any of the reusable batteries that should be replaced, a reduction in the management cost of managing the conditions of the reusable batteries, and management for uninterrupted power supply.

For example, if a vast amount of battery data is transmitted to a facility manager at a remote location and the facility manager analyzes the battery data and determines whether any of the reusable batteries should be replaced, it may take a few days to a few weeks for a process of preparing a desired maintenance part (e.g., a new reusable battery), sending workers to the site where the power storage system is installed, and performing maintenance work such as the replacement of the reusable battery. Herein, the facility manager refers to an organization or individual who manages and appropriately operates a facility such as a power storage system, for example.

In the embodiment, therefore, the conditions of the reusable batteries of the power storage system are monitored in real time at the site where the power storage system is installed, and the result of determining whether any of the reusable batteries should be replaced is transmitted to the facility manager at the remote location. This reduces the time to the action of the next process (e.g., an operations and maintenance (O&M) service such as visiting the site and replacing batteries). Further, the embodiment reduces the cost of the power storage system by using the reusable batteries, and reduces the cost of the operation and the maintenance and inspection to maintain the quality and safety of the reusable batteries, consequently establishing a business model in which a business operator supplies power to a customer with a power storage system using reusable batteries, as described later.

A system configuration of the embodiment will be described.

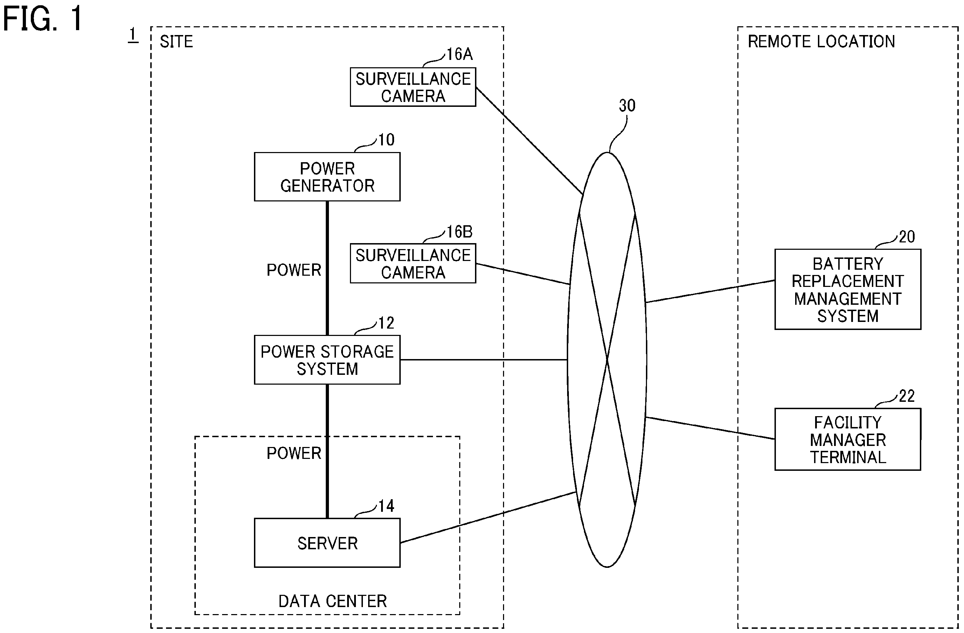

FIG. 1 is a diagram illustrating an exemplary configuration of a battery management system 1 of the embodiment. The battery management system 1 of FIG. 1 includes a power generator 10, a power storage system 12, a server 14, surveillance cameras 16A and 16B, a battery replacement management system 20, and a facility manager terminal 22.

The power storage system 12, the server 14, the surveillance cameras 16A and 16B, the battery replacement management system 20, and the facility manager terminal 22 are connected to each other via a communication network 30 such as the Internet to communicate data to each other.

The site in FIG. 1 is near the data center of the customer as an example of the power supply destination. The power generator 10, the power storage system 12, and the surveillance cameras 16A and 16B are installed at the site.

The power generator 10, such as a solar power generator, generates renewable energy power. The power storage system 12 stores the power generated by the power generator 10. The power storage system 12 includes replaceable storage batteries (battery packs). In the power storage system 12, storage batteries used in EVs or HEVs are employed as reusable batteries. The power storage system 12 supplies power to the server 14 in the data center of the customer, for example.

The surveillance camera 16A captures the image of the power generator 10. For example, the surveillance camera 16A captures the image of solar panels included in the power generator 10. The surveillance camera 16B captures the image of the power storage system 12. For example, the surveillance camera 16B captures the image of the reusable batteries used in the power storage system 12 as the storage batteries.

The power storage system 12 determines whether any of the currently used reusable batteries should be replaced, as described later. Then, if it is determined that any of the currently used reusable batteries should be replaced, the power storage system 12 outputs a battery replacement request to the battery replacement management system 20.

The remote location in FIG. 1 is distant from the data center of the customer, for example. The battery replacement management system 20 at the remote location manages the information of reusable batteries that are usable as the storage batteries. The battery replacement management system 20 receives the battery replacement request from the power storage system 12, and outputs the information of a reusable battery to replace the reusable battery determined to be replaced and the information of a replacement time to replace the reusable battery, for example, to the facility manager terminal 22 operated by the facility manager. Therefore, the facility manager is able to check the information of the reusable battery to replace the reusable battery determined to be replaced and the information of the replacement time to replace the reusable battery, for example, by displaying the information on the facility manager terminal 22.

The battery replacement management system 20 is a personal computer (PC) or a workstation, for example. The battery replacement management system 20 may be implemented by a server, an application service provider (ASP), or cloud computing. The facility manager terminal 22 is a PC, a mobile phone, a smartphone, a tablet terminal, a gaming machine, or a personal digital assistant (PDA), for example.

The configuration of the battery management system 1 illustrated in FIG. 1 is illustrative. For example, at least part of the functions of the power storage system 12 may be included in the server 14. Further, at least part of the functions of the battery replacement management system 20 may be included in the power storage system 12 or the server 14.

A hardware configuration of the battery management system 1 of the embodiment will be described. Description and illustration of parts of the battery management system 1 unnecessary in the description of the embodiment will be omitted as appropriate.

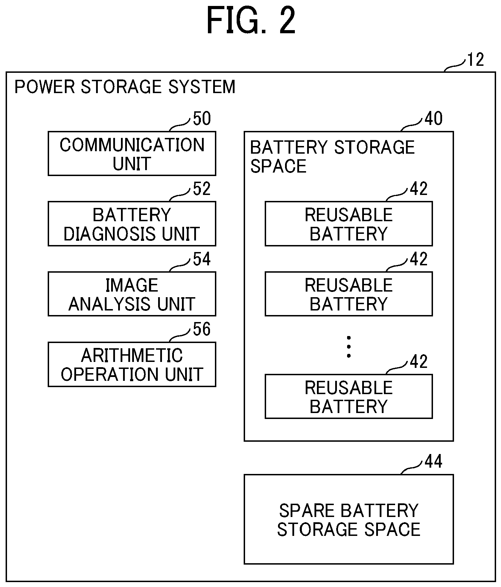

FIG. 2 is a diagram illustrating an exemplary hardware configuration of the power storage system 12 of the embodiment. The power storage system 12 has a battery storage space 40 and a spare battery storage space 44. The battery storage space 40 stores one or more reusable batteries 42. The spare battery storage space 44 is a storage space for storing one or more reusable batteries 42 when the number of batteries to be used is increased due to a change in an operating condition of the reusable batteries 42, as described later.

The power storage system 12 includes a communication unit 50, a battery diagnosis unit 52, an image analysis unit 54, and an arithmetic operation unit 56.

The communication unit 50 is an interface for the power storage system 12 to perform data communication. The communication unit 50 performs data communication with the battery replacement management system 20 via the communication network 30.

The battery diagnosis unit 52 measures the value of at least one of the voltage, current, and temperature of each of the currently used reusable batteries 42 and acquires the measured value as part of the data (i.e., various parameters) of the currently used reusable battery 42. The battery diagnosis unit 52 includes an alternating current (AC) impedance meter, for example. The battery diagnosis unit 52 further performs deterioration diagnosis on the reusable battery 42 based on the acquired data of the reusable battery 42. The battery diagnosis unit 52 may use an existing method to perform the deterioration diagnosis on the reusable battery 42 based on the acquired data of the reusable battery 42.

The image analysis unit 54 acquires the image of the reusable batteries 42 of the power storage system 12 captured by the surveillance camera 16B, and performs image analysis for anomaly diagnosis of the reusable batteries 42. The image analysis unit 54 may acquire the image of the power generator 10 captured by the surveillance camera 16A and the image of the reusable batteries 42 of the power storage system 12 captured by the surveillance camera 16B and perform image analysis for anomaly diagnosis of the power generator 10 and the reusable batteries 42.

The arithmetic operation unit 56, which is a computer, for example, performs various arithmetic operations in accordance programs, as described later. The arithmetic operation unit 56 includes a central processing unit (CPU), a read only memory (ROM), and a random access memory (RAM), for example. The ROM stores programs. The RAM is used as a work area of the CPU. In accordance programs, the CPU performs various arithmetic operations, as described later.

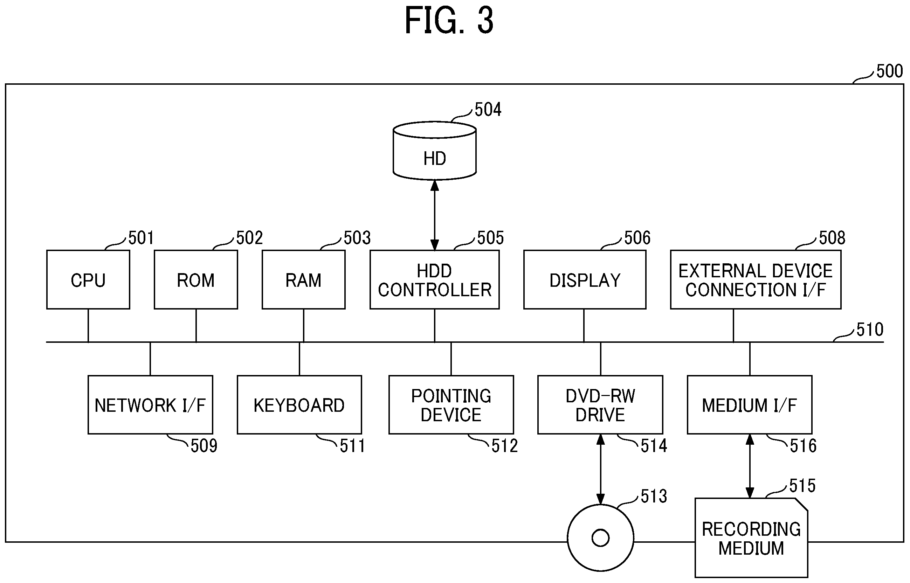

Each of the server 14 and the battery replacement management system 20 in FIG. 1 is implemented by a computer 500 with the hardware configuration illustrated in FIG. 3, for example. If the facility manager terminal 22 in FIG. 1 is a PC, the facility manager terminal 22 is also implemented by the computer 500 with the hardware configuration illustrated in FIG. 3, for example. FIG. 3 is a diagram illustrating an exemplary hardware configuration of the computer 500 of the embodiment.

The computer 500 includes a CPU 501, a ROM 502, a RAM 503, a hard disk (HD) 504, a hard disk drive (HDD) controller 5005, a display 506, an external device connection interface (I/F) 508, a network I/F 509, a data bus 510, a keyboard 511, a pointing device 512, a digital versatile disk-rewritable (DVD-RW) drive 514, and a medium I/F 516.

The CPU 501 controls the operation of the entire computer 500 in accordance with programs. The ROM 502 stores a program used to drive the CPU 501, such as an initial program loader (IPL). The RAM 503 is used as a work area of the CPU 501. The HD 504 stores various data such as programs. The HDD controller 505 controls the writing and reading of various data to and from the HD 504 under the control of the CPU 501.

The display 506 displays various information such as a cursor, menus, windows, text, and images. The external device connection I/F 508 is an interface for connecting various external devices to the computer 500. The external devices include a universal serial bus (USB) memory, for example. The network I/F 509 is an interface for performing data communication via the communication network 30. The data bus 510 includes address buses and data buses for electrically connecting the CPU 501 and the other components to each other.

The keyboard 511 is a type of input means including a plurality of keys for inputting text, numerical values, and various instructions, for example. The pointing device 512 is a type of input means for selecting and executing various instructions, selecting a processing target, and moving the cursor, for example. The DVD-RW drive 514 controls the writing and reading of various data to and from a DVD-RW 513 as an example of a removable recording medium. The removable recording medium is not limited to the DVD-RW, and may be a DVD-recordable (DVD-R), for example. The medium I/F 516 controls the writing (i.e., storage) and reading of data to and from a recording medium 515 such as a flash memory.

The hardware configuration illustrated in FIG. 3 is illustrative. The computer 500 is not necessarily required to include all of the components illustrated in FIG. 3. Further, the computer 500 may include a component other than those illustrated in FIG. 3.

A functional configuration of the battery management system 1 of the embodiment will be described.

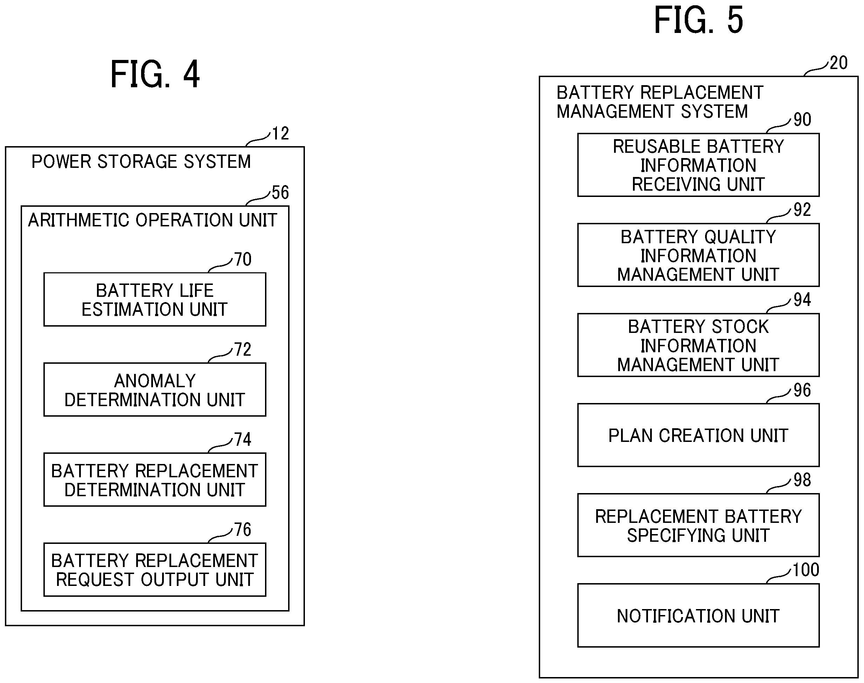

The arithmetic operation unit 56 of the power storage system 12 of the embodiment is configured to have the functions illustrated in FIG. 4, for example. FIG. 4 is a diagram illustrating an exemplary functional configuration of the arithmetic operation unit 56 included in the power storage system 12 of the embodiment. In the functional configuration diagram of FIG. 4, components of the arithmetic operation unit 56 unnecessary in the description of the embodiment are omitted as appropriate. The arithmetic operation unit 56 of the power storage system 12 executes programs to implement the functional configuration of FIG. 4, for example.

The power storage system 12 in FIG. 4 includes a battery life estimation unit 70, an anomaly determination unit 72, a battery replacement determination unit 74, and a battery replacement request output unit 76.

The battery life estimation unit 70 estimates the battery life of the currently used reusable battery 42 based on the result of deterioration diagnosis of the currently used reusable battery 42 by the battery diagnosis unit 52. The battery life estimation unit 70 may use an existing method to estimate the battery life of the reusable battery 42 based on the result of deterioration diagnosis of the reusable battery 42.

The anomaly determination unit 72 performs anomaly diagnosis on the currently used reusable batteries 42 based on the result of image analysis by the image analysis unit 54. For example, the anomaly determination unit 72 diagnoses anomalies such as expansion in the currently used reusable batteries 42. The anomaly determination unit 72 may perform anomaly diagnosis on at least one of the currently used power generator 10 and the currently used reusable batteries 42 based on the result of image analysis by the image analysis unit 54. The anomaly determination unit 72 may use an existing method to perform the anomaly diagnosis on at least one of the currently used power generator 10 and the currently used reusable batteries 42 based on the result of image analysis by the image analysis unit 54.

The battery replacement determination unit 74 determines whether any of the currently used reusable batteries 42 should be replaced based on the battery life of the currently used reusable battery 42 estimated by the battery life estimation unit 70. For example, if the estimated battery life of any of the currently used reusable batteries 42 is less than a particular time period, the battery replacement determination unit 74 determines that the currently used reusable battery 42 should be replaced.

If the battery replacement determination unit 74 determines that any of the currently used reusable batteries 42 should be replaced, the battery replacement request output unit 76 outputs the battery replacement request to the battery replacement management system 20. The battery replacement request output unit 76 may output the battery replacement request to the battery replacement management system 20 in real time or at particular time intervals (e.g., daily).

The battery life estimation unit 70 may estimate the battery life of each of the currently used reusable batteries 42 by simulation based on at least one of the result of deterioration diagnosis of the currently used reusable battery 42 by the battery diagnosis unit 52, the result of anomaly diagnosis by the anomaly determination unit 72, use environment measurement data of the site where the power storage system 12 is installed, and power operation data of the power storage system 12. The functional configuration of FIG. 4 is illustrative, and at least part of the functions of the arithmetic operation unit 56 illustrated in FIG. 4 may be included in the server 14.

The battery replacement management system 20 of the embodiment is configured to have the functions illustrated in FIG. 5, for example. FIG. 5 is a diagram illustrating an exemplary functional configuration of the battery replacement management system 20 of the embodiment. In the functional configuration diagram of FIG. 5, components of the battery replacement management system 20 unnecessary in the description of the embodiment are omitted as appropriate. The battery replacement management system 20 executes programs such as an operating system (OS) and applications to implement the functional configuration of FIG. 5, for example.

The battery replacement management system 20 in FIG. 5 includes a reusable battery information receiving unit 90, a battery quality information management unit 92, a battery stock information management unit 94, a plan creation unit 96, a replacement battery specifying unit 98, and a notification unit 100.

The reusable battery information receiving unit 90 receives, from a battery inspector, the input of reusable battery information including an inspection result such as the deterioration level, the estimated life, and the capacity of a used storage battery collected from an EV or HEV, for example.

Based on the reusable battery information input to and received by the reusable battery information receiving unit 90, the battery quality information management unit 92 manages battery quality information related to the quality of reusable batteries 42 usable in the power storage system 12.

Based on the reusable battery information input to and received by the reusable battery information receiving unit 90, the battery stock information management unit 94 manages battery stock information related to a stock of reusable batteries 42 usable in the power storage system 12.

The plan creation unit 96 creates a plan for the operation and the maintenance and inspection of the power storage system 12. The creation of the plan for the operation and the maintenance and inspection of the power storage system 12 will be described later.

In response to receipt of the battery replacement request from the power storage system 12, the replacement battery specifying unit 98 specifies a reusable battery 42 in the stock (hereinafter referred to as the stock reusable battery 42) to replace the currently used reusable battery 42 determined to be replaced based on the battery quality information managed by the battery quality information management unit 92 and the battery stock information managed by the battery stock information management unit 94.

The notification unit 100 transmits, to the facility manager, the information of the stock reusable battery 42 specified by the replacement battery specifying unit 98. When the battery replacement management system 20 receives the battery replacement request from the power storage system 12, the notification unit 100 thus transmits, to the facility manager, the information of the stock reusable battery 42 to replace the reusable battery 42 currently used in the power storage system 12 and determined to be replaced. When the battery replacement management system 20 receives the battery replacement request from the power storage system 12, the notification unit 100 may further transmit, to the facility manager, the information of the replacement time to replace the reusable battery 42 currently used in the power storage system 12 and determined to be replaced.

The notification unit 100 may further transmit, to the facility manager, the plan for the operation and the maintenance and inspection of the power storage system 12 created by the plan creation unit 96. If there is no stock reusable battery 42 to replace the reusable battery 42 currently used in the power storage system 12 and determined to be replaced, the notification unit 100 may transmit, to the facility manager, a change instruction to change the operating condition of the reusable battery 42 in the power storage system 12. Then, if there is a stock reusable battery 42 meeting the operating condition changed based on the change instruction to change the operating condition of the reusable battery 42 in the power storage system 12, the notification unit 100 may transmit a re-created plan to the facility manager.

A description will be given of a processing procedure of the battery management system 1 of the embodiment.

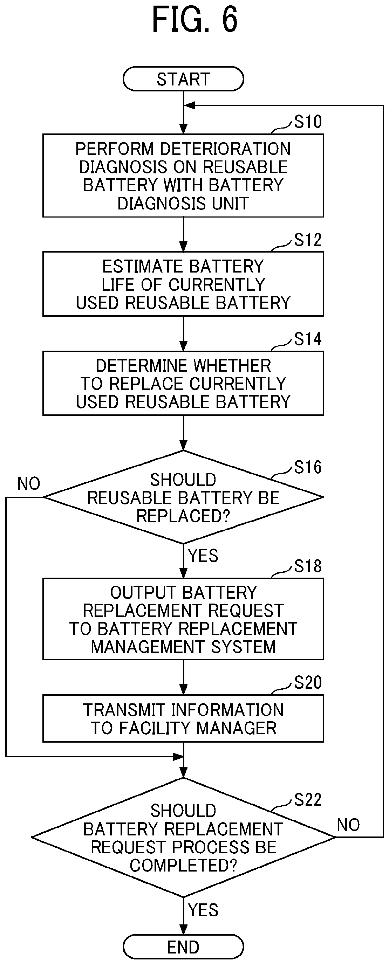

FIG. 6 is a flowchart illustrating an example of a battery replacement request process of the battery management system 1 according to the embodiment.

At step S10, the battery diagnosis unit 52 of the power storage system 12 measures the value of at least one of the voltage, current, and temperature of each of the reusable batteries 42 currently used as the storage batteries, and acquires the measured value as the data of the currently used reusable battery 42. Based on the acquired data of the reusable battery 42, the battery diagnosis unit 52 performs the deterioration diagnosis on the currently used reusable battery 42.

At step S12, based on the result of deterioration diagnosis performed on the currently used reusable battery 42 at step S 10, the battery life estimation unit 70 of the power storage system 12 estimates the battery life of the currently used reusable battery 42.

At step S14, based on the battery life of the currently used reusable battery 42 estimated at step S12, the battery replacement determination unit 74 of the power storage system 12 determines whether the currently used reusable battery 42 should be replaced. For example, if the estimated battery life of the currently used reusable battery 42 is less than a particular time period, the battery replacement determination unit 74 determines that the currently used reusable battery 42 should be replaced. If the estimated battery life of the currently used reusable battery 42 is equal to or more than the particular time period, the battery replacement determination unit 74 determines that it is unnecessary to replace the currently used reusable battery 42.

At step S16, if the battery replacement determination unit 74 determines that any of the currently used reusable batteries 42 should be replaced (YES at step S16), the battery replacement request output unit 76 of the power storage system 12 performs the processes of steps S18 and S20. If the battery replacement determination unit 74 determines that it is unnecessary to replace any of the currently used reusable batteries 42 (NO at step S16), the battery replacement request output unit 76 of the power storage system 12 skips the processes of steps S18 and S20.

At step S18, the battery replacement request output unit 76 of the power storage system 12 outputs, to the battery replacement management system 20, the battery replacement request to replace the currently used reusable battery 42 determined to be replaced by the battery replacement determination unit 74.

At step S20, the notification unit 100 of the battery replacement management system 20 transmits, to the facility manager, the information of the currently used reusable battery 42 corresponding to the battery replacement request, the information of the stock reusable battery 42 to replace the currently used reusable battery 42 determined to be replaced, or the information of the replacement time to replace the currently used reusable battery 42 determined to be replaced.

The information of the currently used reusable battery 42 corresponding to the battery replacement request, the information of the stock reusable battery 42 to replace the currently used reusable battery 42 determined to be replaced, or the information of the replacement time to replace the currently used reusable battery 42 determined to be replaced is displayed on the facility manager terminal 22, for example, to transmit the information to the facility manager.

The battery replacement request process in the flowchart of FIG. 6 is repeated (NO at step S22) until the monitoring of the state of the reusable batteries 42 in the power storage system 12 is stopped.

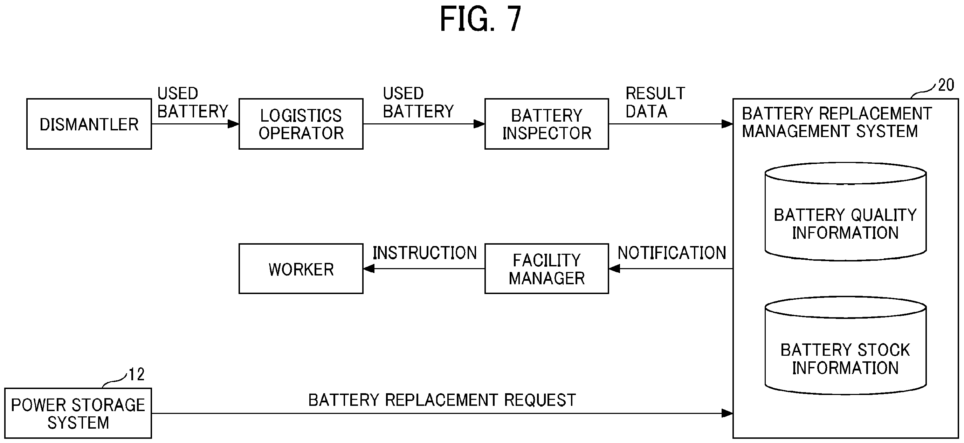

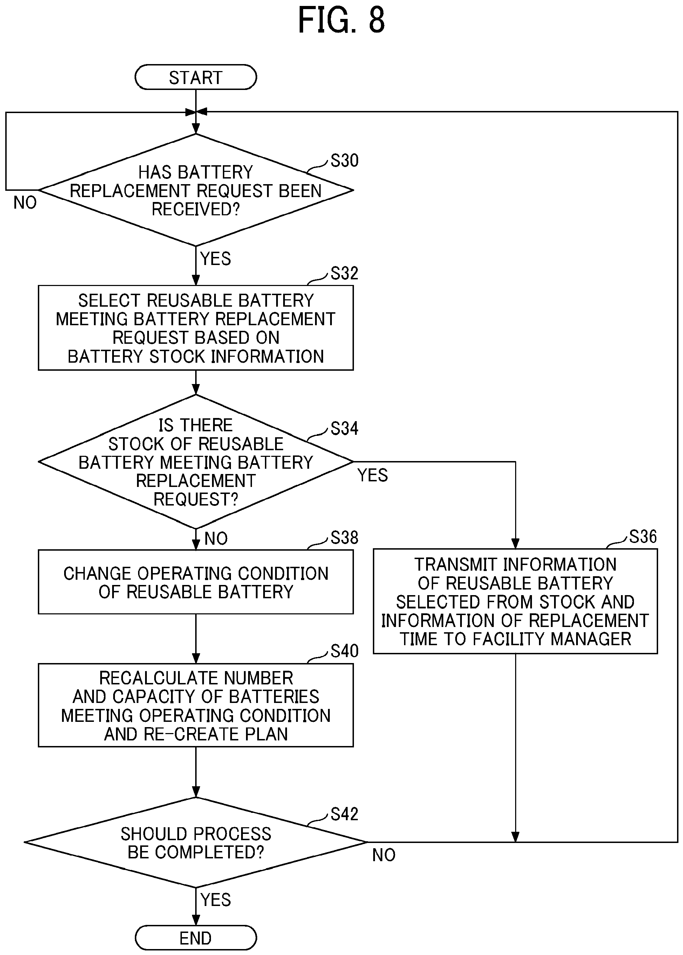

The battery replacement management system 20 of the embodiment performs processes as described below with FIGs. 7 and 8, for example. FIG. 7 is a diagram illustrating an exemplary process of the battery replacement management system 20 of the embodiment. FIG. 8 is a flowchart illustrating an exemplary processing procedure of the battery replacement management system 20 of the embodiment.

As illustrated in FIG. 7, a dismantler dismantles an EV or HEV and collects therefrom a used battery (i.e., used storage battery), for example. A business operator of the battery management system 1 purchases the used battery from the dismantler and has the used battery transported by a logistics operator. For example, if the business operator of the battery management system 1 is a copier manufacturer, the business operator may utilize reverse logistics for collecting copiers (i.e., mixed loading with copiers). The term "reverse logistics" refers to logistics to transport used products used by end-consumers.

A battery inspector inspects, for example, the deterioration level, the estimated life, and the capacity of the used battery transported by the logistics operator. The battery inspector inputs reusable battery information to the battery replacement management system 20. The reusable battery information includes result data (i.e., an inspection result) representing the result of inspecting, for example, the deterioration level, the estimated life, and the capacity of the used battery transported by the logistics operator.

The battery quality information and the battery stock information of the used battery purchased from the dismantler are thus registered in the battery replacement management system 20. In response to receipt of the battery replacement request from the power storage system 12, the battery replacement management system 20 transmits the information of the stock reusable battery 42 to replace the currently used reusable battery 42 determined to be replaced and the information of the replacement time of the reusable battery 42, for example, to the facility manager by causing the facility manager terminal 22 operated by the facility manager to display the information.

Thereby, the facility manager is able to instruct workers to perform replacement work of replacing the currently used reusable battery 42 determined to be replaced. The workers are a unit of personnel for a battery replacement O&M service, for example. The workers visit the site where the power storage system 12 is installed, and perform the replacement work of replacing the currently used reusable battery 42 determined to be replaced with the specified stock reusable battery 42.

At step S30 in FIG. 8, the battery replacement management system 20 determines whether the battery replacement request has been received from the power storage system 12. If it is determined that the battery replacement request has been received from the power storage system 12, the battery replacement management system 20 performs the process of step S32.

At step S32, the replacement battery specifying unit 98 of the battery replacement management system 20 selects a stock reusable battery 42 meeting the battery replacement request based on the battery quality information managed by the battery quality information management unit 92 and the battery stock information managed by the battery stock information management unit 94.

If there is a stock reusable battery 42 meeting the battery replacement request (YES at step S34), the notification unit 100 of the battery replacement management system 20 proceeds to the process of step S36 to transmit the information of the reusable battery 42 selected from the stock and the information of the replacement time to the facility manager.

If there is no stock reusable battery 42 meeting the battery replacement request (NO at step S34), the battery replacement management system 20 proceeds to the process of step S38. At step S38, via the notification unit 100, the replacement battery specifying unit 98 of the battery replacement management system 20 transmits, to the facility manager, a change instruction to change the operating condition of the reusable battery 42 in the power storage system 12. Based on the change instruction to change the operating condition of the reusable battery 42 in the power storage system 12, the facility manager reduces the maximum full charge voltage, for example, to change the operating condition of the reusable battery 42 to be less consuming for the reusable battery 42.

At step S40, the plan creation unit 96 recalculates the number and capacity of batteries to use that meet the changed operating condition. If there is a stock reusable battery 42 meeting the changed operating condition of the reusable battery 42, the plan creation unit 96 re-creates the plan for the operation and the maintenance and inspection of the power storage system 12. The process of the flowchart in FIG. 8 is repeated (NO at step S42) until the monitoring of the state of the reusable batteries 42 in the power storage system 12 is stopped.

According to the battery replacement management system 20 of the embodiment, if there is no stock reusable battery 42 meeting the battery replacement request, the operating condition of the reusable battery 42 in the power storage system 12 is changed. Then, if there is a stock reusable battery 42 meeting the changed operating condition of the reusable battery 42, the plan for the operation and the maintenance and inspection of the power storage system 12 is re-created. Further, the business operator of the battery management system 1 provides the customer with the O&M service based on the re-created plan for the operation and the maintenance and inspection of the power storage system 12.

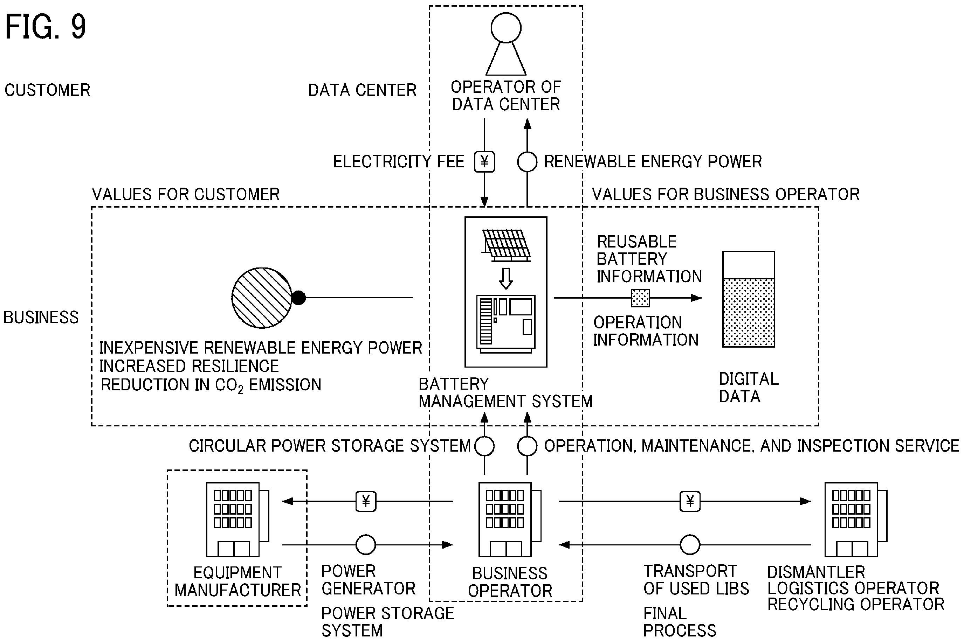

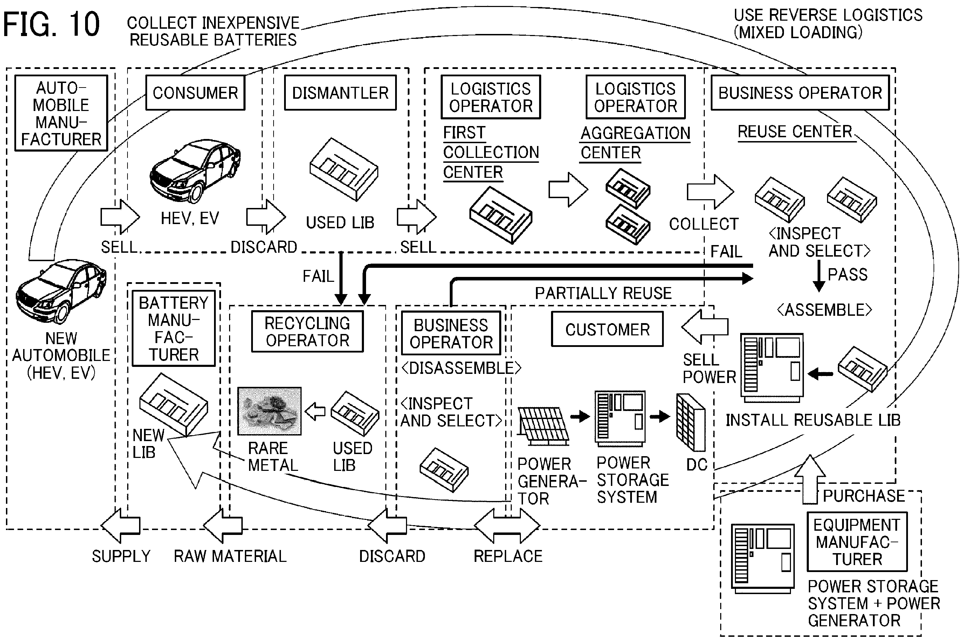

FIG. 9 is a diagram illustrating an exemplary business model implemented by the battery management system 1 of the embodiment. The reusable batteries 42 for use in the business model of FIG. 9 are remanufactured through collection, inspection, and selection processes in a later-described circular flow illustrated in FIG. 10, used in a business of supplying power to customers, and subjected to material recycling by a recycling operator in the final phase of the circular flow.

The business model of FIG. 9 targets customers that aim for decarbonization with renewable energy. For example, the operator of a data center is set as the target of the business model. This is in consideration of increased adoption of technologies such as artificial intelligence (AI), the Internet of Things (IoT), and the fifth generation (5G) due to digital transformation promoted in recent years, which results in enhanced significance of data centers that process data and thus increased power consumption at the data centers as a social issue. In the business model of FIG. 9, a solar power generator and a power storage system provided by a business operator are installed in or near the premises of the data center to supply generated renewable energy power to the operator of the data center as the customer, and the business operator collects electricity fee from the customer.

The business operator further purchases used batteries from a dismantler, requests a logistics operator to transport the purchased used batteries, and requests the recycling operator to perform a final process including the recycling of the used reusable batteries 42. The business operator further purchases the power generator 10 and the power storage system 12 from an equipment manufacturer.

The business model of FIG. 9 uses the battery management system 1 of the embodiment to reduce the cost of the power storage system 12 and the cost of managing the quality of the reusable batteries 42, thereby providing inexpensive renewable energy to the customer.

FIG. 10 is a diagram illustrating an example of the circular flow implemented by the battery management system 1 of the embodiment.

An automobile manufacturer sells an EV or HEV to a consumer. The EV or HEV used and discarded by the consumer is dismantled by a dismantler to collect used lithium-ion batteries (LIBs) from the EV or HEV. A business operator purchases the used LIBs from the dismantler.

If the business operator is a copier manufacturer, the business operator transports the used LIBs purchased from the dismantler by loading the used LIBs with other products (mixed loading) in reverse logistics operating in a copier reuse and recycling business, to thereby efficiently collect the used LIBs to a reuse center.

At the reuse center, the business operator performs inspection and selection on the used LIBs based on standards set for recycling purposes. If the used LIBs meet the standards, the business operator employs the used LIBs as the reusable batteries 42 of the power storage system 12. The business operator further purchases equipment such as a housing, a control circuit, and a peripheral device of the power storage system 12 from an equipment manufacturer, and installs the reusable batteries 42 in the equipment to complete the power storage system 12. The business operator also purchases the power generator 10 such as a solar power generator from the equipment manufacturer. The business operator then combines the power generator 10 and the power storage system 12 to prepare the battery management system 1 to provide to the customer.

The business operator installs the power generator 10 and the power storage system 12 near the data center that supplies renewable energy power. Herein, the business operator does not sell the power generator 10 and the power storage system 12, but executes a business model of selling renewable energy power to the operator of the data center.

The battery management system 1 of the embodiment estimates the battery life of each of the currently used reusable batteries 42 and determines whether any of the currently used reusable batteries 42 should be replaced, to thereby provide a service of uninterruptedly supplying renewable energy power.

In the battery management system 1 of the embodiment, when the battery replacement request for replacing a currently used reusable battery 42 is output, the currently used reusable battery 42 determined to be replaced is removed and replaced with a stock reusable battery 42. The reusable battery 42 determined to be replaced and removed is subjected to the inspection and selection. If tertiary use of the reusable battery 42 is possible, the reusable battery 42 is used for the following purpose. The discarded reusable battery 42 is subjected to the final process by the recycling operator. In the final process, a recyclable material is extracted from the reusable battery 42 by combustion, for example. In the final process, the recyclable material may be extracted from the reusable battery 42 by a process other than combustion. The recycled material is shared by a battery manufacturer as a raw material for a new LIB. The battery manufacturer manufactures the LIB with the raw material supplied by the recycling operator, and supplies the manufactured LIB to the automobile manufacturer.

As described above, the battery management system 1 of the embodiment reduces the cost of the power storage system 12 by using the reusable batteries 42, and also reduces the cost of the operation and the maintenance and inspection of the power storage system 12 for maintaining the quality and safety of the reusable batteries 42. Consequently, the battery management system 1 of the embodiment enables the business model in which the business operator supplies power to the customer with the power storage system 12 using the reusable batteries 42.

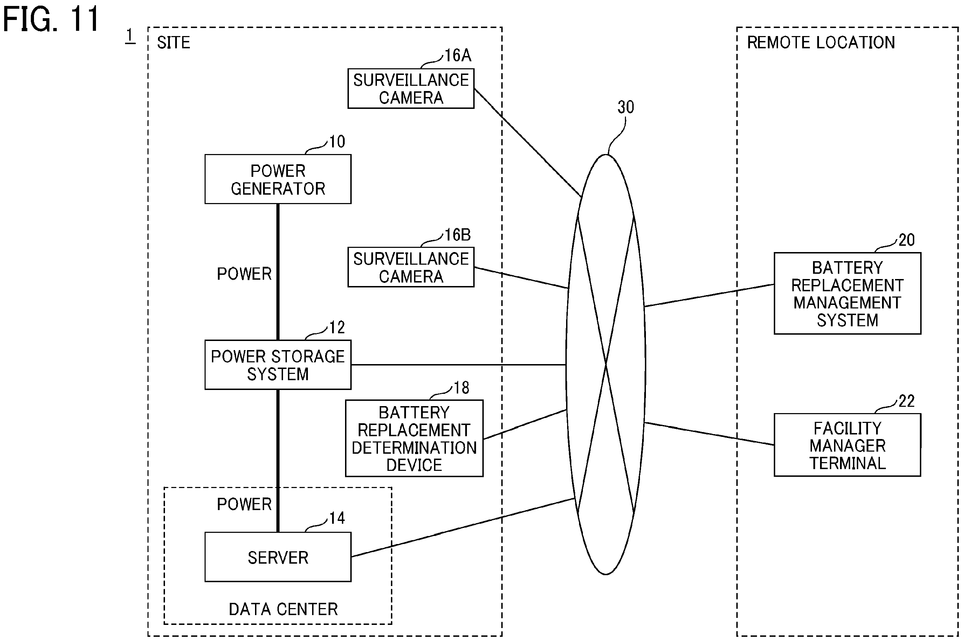

The configuration of the battery management system 1 in FIG. 1 is illustrative. For example, the battery management system 1 may have the configuration illustrated in FIG. 11. FIG. 11 is a diagram illustrating another exemplary configuration of the battery management system 1 of the embodiment. In the configuration of the battery management system 1 in FIG. 11, a battery replacement determination device 18 is added to the battery management system 1 of FIG. 11. The battery replacement determination device 18 is a PC or workstation, for example. The battery replacement management system 20 may be implemented by a server, an ASP, or cloud computing.

With the execution of a program by the CPU 501 in FIG. 3, for example, the battery replacement determination device 18 functions as the battery replacement determination unit 74 and the battery replacement request output unit 76 illustrated in FIG. 4, for example. In the battery management system 1 of FIG. 11, the power storage system 12 estimates the battery life of each of the currently used reusable batteries 42, and the battery replacement determination device 18 determines whether any of the currently used reusable batteries 42 should be replaced. If it is determined that any of the currently used reusable batteries 42 should be replaced, the battery replacement determination device 18 outputs the battery replacement request to the battery replacement management system 20.

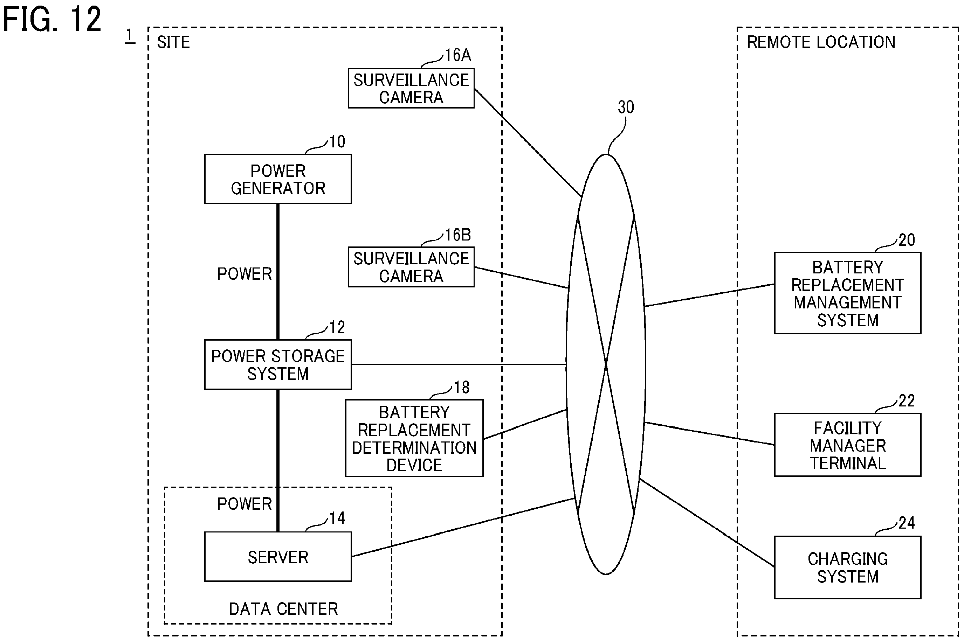

The battery management system 1 of FIG. 1 or 11 may include a charging system 24. FIG. 12 illustrates an exemplary configuration in which the charging system 24 is added to the battery management system 1 of FIG. 11. FIG. 12 is a diagram illustrating another exemplary configuration of the battery management system 1 of the embodiment.

The charging system 24 of the battery management system 1 in FIG. 12 manages a charging plan for the customer (i.e., the operator of the data center) using the renewable energy power supplied from the power storage system 12. The charging system 24 performs a process for collecting the electricity fee from the customer in accordance with the charging plan. The charging system 24 manages the charging plan by determining the charge to the customer based on the amount of power supplied to the customer and charging the business operator of the battery management system 1 for the cost of the operation and the maintenance and inspection of the battery management system 1.

The charging system 24 may offer the customer a charging plan based on possible fluctuations in the maximum power supply amount per unit time as the operating condition, which is changed based on the change instruction.

As an example of the charging plan based on the possible fluctuations in the maximum power supply amount per unit time as the operating condition changed based on the change instruction, the business operator makes a contract with the customer with a maximum power supply amount of 50 kilowatts (kW) when the maximum output of the power generator 10 is 30 kW and the maximum output of the power storage system 12 is 20 kW, for example. Then, if the maximum output of the power storage system 12 drops to 15 kW due to the change in the operating condition, the business operator lowers the fee in accordance with the reduction in the maximum power supply amount from 50 kW to 45 kW due to the change in the operating condition.

With global promotion of digital transformation, technologies such as AI, IoT, and 5G have been increasingly adopted in various fields, resulting in enhanced significance of data centers that process data and an increase in the expected power consumption at the data centers. On the other hand, the departure from thermal power generation with fuel such as coal, fuel oil, or liquified natural gas (LNG) has been sought to reduce carbon dioxide (CO2) emission. There is a method of effectively using a surplus of generated power with a power storage apparatus and a solar power generator that generates solar energy as a type of renewable energy. Storage batteries included in the power storage apparatus, however, are expensive, presenting an obstacle to the spread of the use of renewable energy power.

There is also a method of collecting batteries used in EVs or HEVs and remanufacturing the collected batteries into reusable batteries for cost reduction. However, the reusable batteries entail quality concerns. There is also variation among the reusable batteries. Therefore, a method should be provided which efficiently manages the reusable batteries and performs maintenance such as repair and replacement of the reusable batteries.

The battery management system 1 of the embodiment enables the business model in which the business operator supplies the generated renewable energy power to the customer, i.e., the operator of the data center, and collects the electricity fee from the customer.

The battery management system 1 of the embodiment reduces the cost of the operation and the maintenance and inspection of the power storage system 12 for maintaining the quality and safety of the reusable batteries 42, which has been a major burden on the business operator. Further, with the use of the reusable batteries 42, the battery management system 1 of the embodiment reduces the cost of the power storage system 12, enabling a viable business and business model.

According to the embodiment, the business operator monitors the quality of the reusable batteries 42 currently used in the power storage system 12, and prepares spare reusable batteries 42 for repair or replacement. If it is determined that any of the reusable batteries 42 should be replaced, therefore, replacement work is performed efficiently in a short time. Consequently, the embodiment reduces the burden on the business operator, which leads to a reduction in the electricity fee of the customer.

Further, in terms of business, business activities including collection, inspection, remanufacturing, maintenance, and use of reusable batteries in a service of supplying power to customers are linked to a service of supplying renewable energy power to customers, enabling a business model of supplying renewable energy power.

With the expansion and development of this business model, the use of renewable energy power is expected to spread to the society, contributing to efforts to realize a decarbonized society.

The functionality of the elements disclosed herein may be implemented using circuitry or processing circuitry which includes general purpose processors, special purpose processors, integrated circuits, application specific integrated circuits (ASICs), digital signal processors (DSPs), field programmable gate arrays (FPGAs), conventional circuitry and/or combinations thereof which are configured or programmed to perform the disclosed functionality. Processors are considered processing circuitry or circuitry as they include transistors and other circuitry therein. In the disclosure, the circuitry, units, or means are hardware that carry out or are programmed to perform the recited functionality. The hardware may be any hardware disclosed herein or otherwise known which is programmed or configured to carry out the recited functionality. When the hardware is a processor which may be considered a type of circuitry, the circuitry, means, or units are a combination of hardware and software, the software being used to configure the hardware and/or processor.

The apparatuses described in the embodiment form one of a plurality of computing environments for implementing the embodiment disclosed in the present specification.

The present invention relates to the following aspects, for example.

According to a first aspect, a power storage system includes a reusable battery, a battery diagnosis unit, battery life estimation means, battery replacement determination means, and battery replacement request output means. The reusable battery is used as a storage battery. The battery diagnosis unit outputs a diagnosis result of diagnosing the reusable battery while the reusable battery is being used. The battery life estimation means estimates a battery life of the reusable battery based on the diagnosis result. The battery replacement determination means determines whether to replace the reusable battery based on the estimated battery life. When it is determined to replace the reusable battery, the battery replacement request output means outputs a battery replacement request to a battery replacement management system that manages information of another reusable battery usable as the storage battery.

According to a second aspect, in the power storage system of the first aspect, the battery diagnosis unit acquires at least one of a voltage, a current, and a temperature of the reusable battery as data of the reusable battery, performs deterioration diagnosis on the reusable battery based on the acquired data of the reusable battery, and outputs a result of the deterioration diagnosis.

According to a third aspect, the power storage system of the first or second aspect further includes an anomaly determination unit that performs anomaly diagnosis on the reusable battery based on a result of analyzing a captured image of the reusable battery, and outputs a result of the anomaly diagnosis.

According to a fourth aspect, in the power storage system of the third aspect, the battery life estimation means estimates, by simulation, the battery life of the reusable battery based on at least one of the diagnosis result, the result of the anomaly diagnosis, use environment measurement data of a site where the power storage system is installed, and power operation data of the power storage system.

According to a fifth aspect, a battery management system includes a power generator and a power storage system that stores power generated by the power generator. The power storage system includes a reusable battery, a battery diagnosis unit, battery life estimation means, battery replacement determination means, and battery replacement request output means. The reusable battery is used as a storage battery. The battery diagnosis unit outputs a diagnosis result of diagnosing the reusable battery while the reusable battery is being used. The battery life estimation means estimates a battery life of the reusable battery based on the diagnosis result. The battery replacement determination means determines whether to replace the reusable battery based on the estimated battery life. When it is determined to replace the reusable battery, the battery replacement request output means outputs a battery replacement request to a battery replacement management system that manages information of another reusable battery usable as the storage battery.

According to a sixth aspect, in the battery management system of the fifth aspect, the battery diagnosis unit acquires at least one of a voltage, a current, and a temperature of the reusable battery as data of the reusable battery, performs deterioration diagnosis on the reusable battery based on the acquired data of the reusable battery, and outputs a result of the deterioration diagnosis to the battery life estimation means.

According to a seventh aspect, in the battery management system of the fifth or sixth aspect, the power storage system further includes an anomaly determination unit that performs anomaly diagnosis on at least one of the reusable battery and the power generator based on a result of analyzing a captured image of at least one of the reusable battery and the power generator, and outputs a result of the anomaly diagnosis.

According to an eighth aspect, in the battery management system of the seventh aspect, the battery life estimation means estimates, by simulation, the battery life of the reusable battery based on at least one of the diagnosis result, the result of the anomaly diagnosis, use environment measurement data of a site where the power storage system is installed, and power operation data of the power storage system.

According to a ninth aspect, the battery management system of one of the fifth to eighth aspects further includes the battery replacement management system. The battery replacement management system includes battery quality information management means, battery stock information management means, and notification means. The battery quality information management means manages battery quality information related to quality of the another reusable battery. The another reusable battery is a recycled battery. The battery stock information management means manages battery stock information related to a stock of the another reusable battery. In response to receipt of the battery replacement request, the notification means transmits reusable battery information to a facility manager based on the battery quality information and the battery stock information of the another reusable battery. The reusable battery information is information of the another reusable battery to replace the reusable battery determined to be replaced.

According to a tenth aspect, in the battery management system of the ninth aspect, the notification means transmits replacement time information to the facility manager based on the battery quality information and the battery stock information of the another reusable battery. The replacement time information is information of a time to replace the reusable battery determined to be replaced.

According to an eleventh aspect, the battery management system of the tenth aspect further includes plan creation means that creates a plan for an operation and a maintenance and inspection of the power storage system based on the reusable battery information of the another reusable battery to replace the reusable battery determined to be replaced and the replacement time information of the time to replace the reusable battery determined to be replaced. The plan creation means transmits the created plan to the facility manager via the notification means.

According to a twelfth aspect, in the battery management system of the tenth or eleventh aspect, the battery replacement management system further includes replacement battery specifying means that, based on the battery quality information and the battery stock information of the another reusable battery, specifies, in the battery stock information, the another reusable battery to replace the reusable battery determined to be replaced. In absence of a stock of the another reusable battery to replace the reusable battery determined to be replaced, the replacement battery specifying means transmits a change instruction to the facility manager via the notification means to change an operating condition of the reusable battery in the power storage system.

According to a thirteenth aspect, in the battery management system of the eleventh aspect, when an operating condition of the reusable battery is changed based on a change instruction to change the operating condition of the reusable battery and there is a stock of the another reusable battery meeting the changed operating condition of the reusable battery, the plan creation means re-creates the plan and transmits the re-created plan to the facility manager.

According to a fourteenth aspect, the battery management system of the twelfth or thirteenth aspect further includes a charging system that manages a charging plan for a customer who uses power supplied from the power storage system. The charging system determines a charge to the customer based on an amount of power supplied to the customer, and charges a business operator of the battery management system for a cost of an operation and a maintenance and inspection of the battery management system.

According to a fifteenth aspect, in the battery management system of the fourteenth aspect, the charging system offers the customer a charging plan based on a possible change in a maximum power supply amount per unit time as the operating condition changed based on the change instruction.

Any one of the above-described operations may be performed in various other ways, for example, in an order different from the one described above.

The present invention can be implemented in any convenient form, for example using dedicated hardware, or a mixture of dedicated hardware and software. The present invention may be implemented as computer software implemented by one or more networked processing apparatuses. The processing apparatuses include any suitably programmed apparatuses such as a general purpose computer, a personal digital assistant, a Wireless Application Protocol (WAP) or third-generation (3G)-compliant mobile telephone, and so on. Since the present invention can be implemented as software, each and every aspect of the present invention thus encompasses computer software implementable on a programmable device. The computer software can be provided to the programmable device using any conventional carrier medium (carrier means). The carrier medium includes a transient carrier medium such as an electrical, optical, microwave, acoustic or radio frequency signal carrying the computer code. An example of such a transient medium is a Transmission Control Protocol/Internet Protocol (TCP/IP) signal carrying computer code over an IP network, such as the Internet. The carrier medium may also include a storage medium for storing processor readable code such as a floppy disk, a hard disk, a compact disc read-only memory (CD-ROM), a magnetic tape device, or a solid state memory device.

## Claims

1. A power storage system (12) comprising:
a reusable battery (42) used as a storage battery;
a battery diagnosis unit (52) configured to output a diagnosis result of diagnosing the reusable battery (42) while the reusable battery (42) is being used;
a battery life estimation unit (70) configured to estimate a battery life of the reusable battery (42) based on the diagnosis result;
a battery replacement determination unit (74) configured to determine whether to replace the reusable battery (42) based on the estimated battery life; and
a battery replacement request output unit (76) configured to, when it is determined to replace the reusable battery (42), output a battery replacement request to a battery replacement management system (20) that manages information of another reusable battery (42) usable as the storage battery.

2. The power storage system (12) of claim 1, wherein the battery diagnosis unit (52) is configured to
acquire at least one of a voltage, a current, and a temperature of the reusable battery (42) as data of the reusable battery (42),
perform deterioration diagnosis on the reusable battery (42) based on the acquired data of the reusable battery (42), and
output a result of the deterioration diagnosis to the battery life estimation unit (70).

3. The power storage system (12) of claim 1 or 2, further comprising:
an anomaly determination unit (72) configured to perform anomaly diagnosis on the reusable battery (42) based on a result of analyzing a captured image of the reusable battery (42), and output a result of the anomaly diagnosis.

4. The power storage system (12) of claim 3, wherein the battery life estimation unit (70) is configured to estimate, by simulation, the battery life of the reusable battery (42) based on at least one of the diagnosis result, the result of the anomaly diagnosis, use environment measurement data of a site where the power storage system (12) is installed, and power operation data of the power storage system (12).

5. A battery management system (1) comprising:
a power generator (10); and
the power storage system (12) of claim 1 or 2 to store power generated by the power generator (10).

6. The battery management system (1) of claim 5, wherein the power storage system (12) further includes
an anomaly determination unit (72) configured to perform anomaly diagnosis on at least one of the reusable battery (42) and the power generator (10) based on a result of analyzing a captured image of at least one of the reusable battery (42) and the power generator (10), and output a result of the anomaly diagnosis.

7. The battery management system (1) of claim 6, wherein the battery life estimation unit (70) is configured to estimate, by simulation, the battery life of the reusable battery (42) based on at least one of the diagnosis result, the result of the anomaly diagnosis, use environment measurement data of a site where the power storage system (12) is installed, and power operation data of the power storage system (12).

8. The battery management system (1) of any one of claims 5 to 7, further comprising:
the battery replacement management system (20) including
a battery quality information management unit (92) configured to manage battery quality information related to quality of the another reusable battery (42), the another reusable battery (42) being a recycled battery,
a battery stock information management unit (94) configured to manage battery stock information related to a stock of the another reusable battery (42), and
a notification unit (100) configured to, in response to receipt of the battery replacement request, transmit reusable battery information to a terminal operated by a facility manager based on the battery quality information and the battery stock information of the another reusable battery (42), the reusable battery information being information of the another reusable battery (42) to replace the reusable battery (42) determined to be replaced.

9. The battery management system (1) of claim 8, wherein in response to receipt of the battery replacement request, the notification unit (100) is configured to transmit replacement time information to the terminal operated by the facility manager based on the battery quality information and the battery stock information of the another reusable battery (42), the replacement time information being information of a time to replace the reusable battery (42) determined to be replaced.

10. The battery management system (1) of claim 9, wherein the battery replacement management system (20) further includes a plan creation unit (96) configured to
create a plan for an operation and a maintenance and inspection of the power storage system (12) based on the reusable battery information and the replacement time information, and
transmit the created plan to the terminal operated by the facility manager via the notification unit (100).

11. The battery management system (1) of claim 9 or 10, wherein the battery replacement management system (20) further includes a replacement battery specifying unit (98) configured to
based on the battery quality information and the battery stock information of the another reusable battery (42), specify, in the battery stock information, the another reusable battery (42) to replace the reusable battery (42) determined to be replaced, and
in absence of a stock of the another reusable battery (42) to replace the reusable battery (42) determined to be replaced, transmit a change instruction to the terminal operated by the facility manager via the notification unit (100) to change an operating condition of the reusable battery (42) in the power storage system (12).

12. The battery management system (1) of claim 10, wherein when an operating condition of the reusable battery (42) is changed based on a change instruction to change the operating condition of the reusable battery (42) and there is a stock of the another reusable battery (42) meeting the changed operating condition of the reusable battery (42), the plan creation unit (96) re-creates the plan and transmits the re-created plan to the terminal operated by the facility manager.

13. The battery management system (1) of claim 11 or 12, further comprising a charging system (24) configured to manage a charging plan for a customer who uses power supplied from the power storage system (12),
wherein the charging system (24) is configured to
determine a charge to the customer based on an amount of power supplied to the customer, and
determine a charge to a business operator of the battery management system (1) based on a cost of an operation and a maintenance and inspection of the battery management system (1).

14. The battery management system (1) of claim 13, wherein the charging system (24) is configured to create the charging plan for the customer based on a possible change in a maximum power supply amount per unit time as the operating condition changed based on the change instruction.
